# EUROPEAN PATENT SPECIFICATION

(11) **EP 1 761 655 B1**
(45) Date of publication and mention of the grant of the patent: **02.12.2009**
(21) Application number: 04800055.8
(22) Date of filing: 06.11.2004
(51) Int. Cl.: C23C 14/14

(54) **METHOD FOR MANUFACTURING ULTRA-HYDROPHILIC THIN FILM COATED METAL PRODUCT, AND ULTRA-HYDROPHILIC THIN FILM COATED METAL PRODUCT**
VERFAHREN ZUR HERSTELLUNG EINES MIT EINEM ULTRAHYDROPHILEN DÜNNEN FILM ÜBERZOGENEN METALLPRODUKTS UND MIT EINEM ULTRAHYDROPHILEN DÜNNEN FILM ÜBERZOGENES METALLPRODUKT
PROCEDE POUR LA FABRICATION DE PRODUIT METALLIQUE REVETU DE FILM MINCE ULTRA HYDROPHILE ET PRODUIT METALLIQUE REVETU DE FILM ULTRA HYDROPHILE

(30) Priority: 06.04.2004 KR 2004023446
(43) Date of publication of application: 14.03.2007
(73) Proprietor: LG Electronics, Inc., Seoul 150-010 (KR)
(72) Inventor: JEONG, Young-Man, c/o LG Electronics, Res.Lab., Kyungsangnam-Do 641-711 (KR); OH, Jung-Geun c/o, Rs. Lab. Digital Appl. Company, Kyungsangnam-do, 641-711 (KR); JUN, Hyun-Woo c/o, Res.Lab., Digit.Appl.Comp., Changwon-shi, Kyungsangnam-Do 641-711 (KR); LEE, Su-Won, Daedong-Hwangtobang, Changwon-Shi Kyungsangnam-Do641-100 (KR); YOUN, Deok-Hyun, Anyang-Shi, Kyunggi-Do 430-030 (KR)
(74) Representative: Office Freylinger
(86) International application number: PCT/KR2004/002868
(87) International publication number: WO 2005/098074

(56) References cited:
- WO-A1-99/28530
- CN-A- 1 420 207
- JP-A- 2001 280 879
- US-A- 6 007 875
- US-A- 2002 041 967
- US-B1- 6 297 175

## Description

### TECHNICAL FIELD

The present invention relates to a method for manufacturing an ultra-hydrophilic thin film coated metal product, and an ultra-hydrophilic thin film coated metal product.

### BACKGROUND ART

Metal materials having hydrophilic surface layers on their surfaces have been efficiently used in the whole industrial fields, which will now be explained by using a heat exchanger as an example.

A heat exchanger exchanging heat by making two fluids having different temperatures directly or indirectly contact each other has been widely used in various industrial fields, especially for heating, air conditioning, power generation, waste heat recovery and chemical processes.

An air conditioning heat exchanger forms a fin that is an enlarged surface at the air side to improve heat transmission. When the air having humidity passes through the fin in the heat exchange operation, heat transmission occurs by low temperature refrigerants supplied into a tube. When a temperature of the surface of the fin is equal to or lower than a dew point temperature of the air having humidity, droplets are formed on the surface of the heat exchanger to intercept flow of the air, which increases a pressure drop that is a pressure difference between the inlet and outlet of the heat exchanger. Accordingly, power of a fan must be increased to supply the same flux, which results in large power consumption.

In order to solve the above problem, as disclosed in Japanese Laid-Open Patent Application 61-8598, flow of condensed water formed on a surface of a fin of a heat exchanger is improved by performing an anti-corrosive process on an aluminum sheet of the fin by using Cr⁺⁶ to improve corrosion resistance, and performing a silicate-group coating process thereon to give hydro philicity, which is called a pre-coated material (PCM).

The PCM basically requires Cr⁺⁶ to obtain corrosion resistance. However, Cr⁺⁶ will be prevented since 2006 due to environmental problems. There are thus increasing demands for a material substituting for Cr⁺⁶. Until now, Cr⁺³ or resin type has been suggested. In the preparation of the PCM, tetrachloroethane (TCE) inevitably used to wash aluminum also causes environmental contamination. In addition, the PCM showing excellent hydrophilic performance at an initial stage gradually loses the hydrophilic property, namely, has an aging characteristic. Recently, chemical products have been mostly used as materials for wallpaper. The silicate material for giving hydrophilicity is volatilized and chemically coupled with the wall paper, thereby discoloring the wall paper. Also, the volatilized materials displease people.

Continuous attempts have been made to satisfy various demands by forming a functional surface layer (for example, hydrophilicity or hydrophobicity) on the existing material. Exemplary methods for forming the functio nal surface layer include 1) depositing the functional surface layer on the existing material, and 2) giving new physical and chemical properties by improving the surface film of the existing material.

However, in the latter, as the time elapses, the surface pro perty is changed and returns to the original property. For example, in the case that a metal such as aluminum is processed according to an ion beam assisted reaction process, hydrophilicity of the surface of the metal is improved. It is because a natural oxide film is etched on the surface of the aluminum and the functional film is formed thereon. As the time elapses, an oxide film is naturally grown on the surface of the aluminum. As a result, hydrophilicity improvement effects obtained by etching the natural oxide film are deteriorated. The functional film formed on the surface of the aluminum is made of an extremely thin layer (< a few nm) having very low mechanical resistance to environmental variations (water, temperature, etc.) by time. Accordingly, the improved hydrophilic property is reduced and returns to the original surface property.

In order to solve the foregoing problem, efforts have been continuously made to form on a metal material a hydrophilic or hydrophobic functional surface layer that can maintain a physically chemically stable state.

For example, as suggested in Japanese Laid-Open Patent Application 2001-280879, in a h eat exchanger mounting a f in m ade of a conductive metal material on a metal tube that is a refrigerant passage, compound vapor containing titanium that is raw gas is supplied to flow in parallel to the surface of the fin of the heat exchanger in the air. Therefore, the heat exchanger coating the titanium dioxide thin film on the surface of the fin is manufactured according to a plasma CVD technology. The above patent application teaches that the heat exchanger can obtain excellent hydrophilic, antibacterial and deodorizing properties.

CN 1 420 207 discloses a method for depositing a corrosion protecting and high polymer hydrophilic film on both sides of an aluminium sheet by continuous plasma assisted CVD. The Al-shut can be used as a fin in heat exchanger.

However, in a state where the fin is mounted on the tube to compose the heat exchanger, the titanium dioxide thin film is deposited on the fin of the heat exchanger. Thus, the titanium dioxide thin film cannot be uniformly deposited on the whole surface of the fin, which deteriorates hydrophilic and aging properties. Furthermore, productivity for direct application to the industrial production is not attained.

### DISCLOSURE OF THE INVENTION

The present invention is achieved to solve the above problems. An object of the present invention is to provide a method for manufacturing an uitra-hydrophilic thin film coated metal product having excellent hydrophilic and aging properties, and an ultra-hydrophilic thin film coated metal product

Another object of the present invention is to easily produce an ultra-hydrophilic thin film on an industrial production scale, by forming the ultra-hydrophilic thin film on a sheet-shaped metal substrate and mechanically processing the metal substrate into a target shape.

Yet another object of the present invention is to uniformly form an ultra-hydrophilic thin film on both surfaces of a sheet-shaped metal substrate.

In order to achieve the above-described objects of the invention, there is provided a method for manufacturing a ultra-hydrophilic thin film coated metal product, which continuously coats a ultra-hydrophilic titanium compound thin film on both surfaces of a continuously-supplied sheet-shaped metal substrate in a vacuum chamber by using plasma, and mechanically processes the thin film coated sheet into a target shape. Here, the thin film is a Ti-O group compound thin film. Preferably, the thin film is a Ti-O group compound thin film containing 15 to 22 atomic% of Ti, 45 to 65 atomic% of O. In addition, the thin film further contains 20 to 25 atomic% of C. Preferably, the thin film further contains 20 atomic% of H. Here, the thin film has a thickness of 1 to 100nm.

The metal substrate can be an aluminum substrate, and the metal product can be a fin for a heat exchanger.

The coating process is performed by injecting reactive gas, gas-phase titanium precursor and carrier gas into the vacuum chamber. Preferably, the gas injection ratio satisfies carrier gas : reactive gas = 1 : 3, and also satisfies gas-phase titanium precursor: carrier gas = 3 : 1.

Preferably, the reactive gas is air or O₂, the carrier gas is selected from the group consisting of He, N₂ and Ar, and the gas-phase titanium precursor is prepared by passing liquid-phase titanium tetraisopropoxide through a bubbler. In addition, the injection amount of the gas-phase titanium precursor into the vacuum chamber is controlled by adjusting the amount of the liquid-phase titanium tetraisopropoxide supplied to the bubbler. The carrier gas is injected before the liquid-phase titanium tetraisopropoxide is injected into the bubbler, for transferring the liquid-phase titanium tetraisopropoxide to the bubbler.

There is also provided a ultra-hydrophilic thin film coated metal product, which is coated with a ultra-hydrophilic Ti-O group compound thin film containing 15 to 22 atomic% of Ti, 45 to 65 atomic% of O and 20 to 25 atomic% of C at a thickness of 1 to 1 00nm by using plasma. Preferably, the thin film further contains 20 atomic% of H. The thin film has an amorphous structure and the metal sheet is an aluminum sheet. The thin film coated aluminum sheet is a metal sheet that can be mechanically processed into a fin for a heat exchanger.

### BRIEF DESCRIPTION OF THE DRAWINGS

The present invention will become better understood with reference to the accompanying drawings which are given only by way of illustration and thus are not limitative of the present invention, wherein:
Fig. 1 is a concept view illustrating a device for continuously coating a ultra-hydrophilic titanium compound thin film on a sheet-shaped metal substrate by using plasma in accordance with the present invention;
Fig. 2 is a graph showing XPS data for analyzing composition of the surface of the anticorrosive hydrophilic thin film coated metal sheet in accordance with the present invention;
Fig. 3 is a graph showing AES data for analyzing thickness of the coated thin film in accordance with the present invention;
Fig. 4 is an SEM photograph showing the microstructure of the coated titanium compound thin film in accordance with the present invention;
Figs. 5a and 5b are photographs respectively showing dispersion of droplets when the surface is hydrophilic (Fig. 5a) and when the surface is hydrophobic (Fig. 5b) in a surface hydrophilicity/hydrophobicity test in accordance with the present invention;
Fig. 6 is a graph showing aging properties of the bare Al sheet, the conventional PCM sheet and the titanium compound thin film coated sheet of the present invention;
Fig. 7 is a graph showing aging properties of the titanium compound thin film coated sheet of the present invention and the conventional PCM sheet; and
Fig. 8 is a graph showing variable test results of titanium compound thin film coating in accordance with the present invention.

### BEST MODE FOR CARRYING OUT THE INVENTION

A method for manufacturing a ultra-hydrophilic thin film coated metal product, and a ultra-hydrophilic thin film coated metal product in accordance with the present invention will now be described in detail with reference to the accompanying drawings.

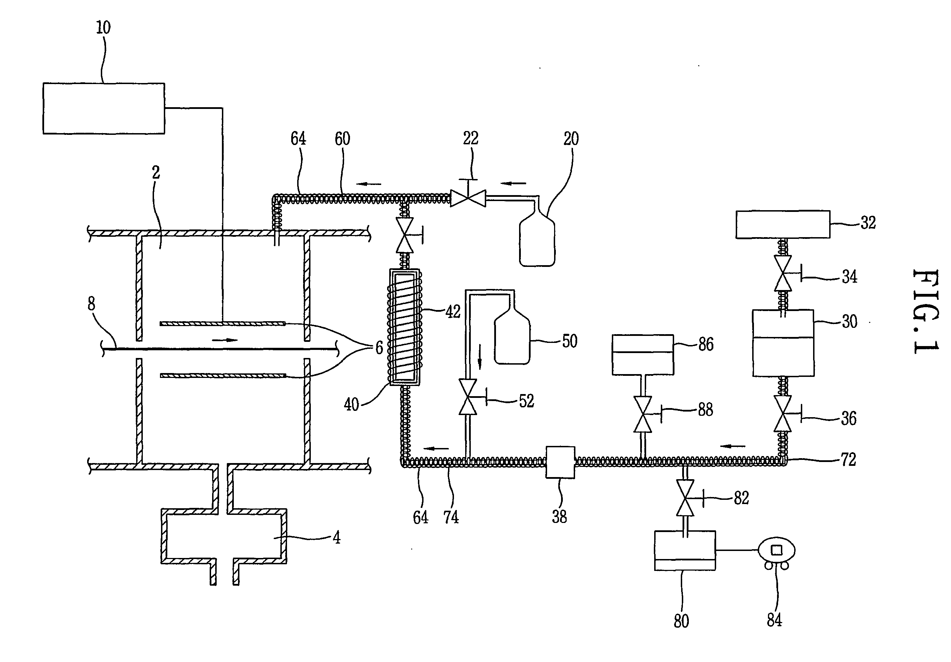

Fig. 1 is a concept view illustrating a plasma polymerization device for coating an ultra-hydrophilic Ti-O-C group compound thin film on a sheet-shaped metal substrate in accordance with the present invention. The polymerization device includes a coating chamber maintained in a vacuum state, plasma being formed inside the coating chamber, a reactive gas injecting means for injecting reactive gas into the coating chamber, a gas-phase precursor injecting means for injecting a gas-phase precursor into the coating chamber, and a carrier gas injecting means for injecting carrier gas for transferring the gas-phase precursor into the coating chamber.

A vacuum pump 4 for forming a vacuum inside the coating chamber 2 is connected to the coating chamber 2, and a metal sheet 8 is continuously supplied between electrodes 6 installed at the upper and right portions or the right and left sides. In Fig. 1, the electrodes 6 are installed at the upper and lower portions of the metal sheet 8, and the metal sheet 8 is supplied in the horizontal direction. After a n ultra-hydrophilic titanium compound thin film is continuously coated on both surfaces of the metal sheet 8 by the plasma generated between the electrodes 6, the metal sheet 8 is discharged from the coating chamber 2. Power 10 is applied to the electrodes 6.

Preferably, a reactive gas cylinder 20 containing reactive gas that can form air or oxygen injects the reactive gas to the coating chamber 2 through a valve 22.

In addition, a liquid-phase titanium precursor that is liquid-phase titanium tetraisopropoxide [Ti(OC₃H₇)₄] contained in a containing vessel 30 pressurized by a pressurizer 32 is injected into a bubbler 40 through a liquid-phase mass flow controller (MFC) 38 due to pressure differences. A gas-phase titanium precursor bubbled by the bubbler 40 is injected into the coating member 2. Preferably, carrier gas that can form He, Ar or N₂ is injected through a tube between the liquid-phase MFC 38 and the bubbler 40, for helping the gas-phase titanium precursor to be injected into the coating chamber 2. The carrier gas is contained in a carrier gas cylinder 50 and injected into the tube through a valve 52. A heater coil 42 is coiled around the bubbler 40 to heat and bubble the liquid-phase titanium precursor. As described above, the coating process using nano plasma is executed by injecting the reactive gas that can form air or O₂, the gas-phase titanium precursor and the carrier gas into the coating chamber 2. The injection amount of the gas-phase titanium precursor into the coating chamber 2 is controlled by adjusting the amount of the liquid-phase precursor supplied to the bubbler 40, namely, the liquid-phase titanium tetraisopropoxide.

Here, the reactive gas, the gas-phase titanium precursor and the carrier gas can be combined outside the coating chamber 2 and injected into the coating chamber 2 through one tube 60 as shown in Fig. 1, or can be injected into the coating chamber 2 through different tubes and combined inside the coating chamber 2 through one tube. Still referring to Fig. 1, the combining tube 60 is connected through one side hole of the coating chamber 2. Preferably, the outlet of the tube 60 is adjacent to the top and bottom surfaces of the coated metal sheet 8 in order to discharge the mixed gas injected through the tube 60 in the up/down direction of the metal sheet 8.

The gas-phase titanium precursor is condensed at a low temperature. When the tube 60 is maintained at a normal temperature, the gas-phase titanium precursor is condensed on the inner wall of the tube 60. In order to prevent condensation of the gas-phase titanium precursor, a hot wire 64 is coiled around the outer wall of the tube 60 through which the gas-phase titanium precursor gas flows, for maintaining a predetermined temperature. A tube 66 through which the liquid-phase titanium precursor flows is also formed in the same manner. That is, a hot wire 68 is coiled around the outer wall of the tube 66, for maintaining a predetermined temperature, thereby preventing the titanium precursor from being condensed on the inner wall of the tube 66.

In accordance with the present invention, the ultra-hydrophilic titanium compound thin film is continuously coated on the metal sheet 8 continuously supplied to the coating chamber 2 by using the plasma, and the thin film coated metal sheet 8 is mechanically processed into a target shape, for example, a fin of an air conditioning heat exchanger.

As illustrated in Fig. 1, the vacuum pump 4 for forming the vacuum inside the coating chamber 2 is connected to the coating chamber 2, and the metal sheet 8 is continuously supplied between the electrodes 6 installed at the upper a nd lower sides. After the ultra-hydrophilic titanium compound thin film is continuously coated on both surfaces of the metal sheet 8 by the plasma generated between the electrodes 6, the metal sheet 8 is discharged from the coating chamber 2. Here, power 10 is applied to the electrodes 6.

Preferably, the reactive gas cylinder 20 containing the reactive gas that can form air or oxygen injects the reactive gas to the coating chamber 2 through the valve 22.

In addition, the liquid-phase titanium precursor that is liquid-phase titanium tetraisopropoxide [Ti(OC₃H₇)₄] contained in the containing vessel 30 pressurized by the pressurizer 32 is injected into the bubbler 40 through the liquid-phase MFC 38 due to pressure differences. The gas-phase titanium precursor bubbled by the bubbler 40 is injected into the coating member 2. Preferably, the carrier gas that can form He or Ar is injected through the tube between the liquid-phase MFC 38 and the bubbler 40, for helping the gas-phase titanium precursor and the gas-phase silicon precursor to be injected into the coating chamber 2. The carrier gas is contained in the carrier gas cylinder 50 and injected into the tube through the valve 52. The heater coil 42 is coiled around the bubbler 40 to heat and bubble the liquid-phase titanium precursor.

Here, the reactive gas, the gas-phase titanium or silicon precursor and the carrier gas can be combined outside the coating chamber 2 and injected into the coating chamber 2 through one tube 60 as shown in Fig. 1, or can be injected into the coating chamber 2 through different tubes and combined inside the coating chamber 2 through one tube. Still referring to Fig. 1, the combining tube 60 is connected through one side hole of the coating chamber 2. Preferably, the mixed gas injected through the tube 60 is discharged in the up/down direction of the coated metal sheet 8. That is, the mixed gas is supplied in the up/down direction of the metal sheet 8, for generating the plasma between the upper and lower electrodes 6, thereby forming the titanium compound thin film on both surfaces of the metal sheet 8.

The gas-phase titanium or silicon precursor is condensed at a low temperature. When the tube 60 is maintained at a normal temperature, the gas-phase titanium precursor is condensed on the inner wall of the tube 60. In order to prevent condensation of the gas-phase titanium precursor, the hot wire 64 is coiled around the outer wall of the tube 60 through which the gas-phase titanium precursor gas flows, for maintaining a predetermined temperature. The tube 66 through which the liquid-phase titanium precursor flows is also formed in the same manner. That is, the hot wire 68 is coiled around the outer wall of the tube 66, for maintaining a predetermined temperature, thereby preventing the titanium or silicon precursor from being condensed on the inner wall of the tube 66.

Reference numerals 34 and 36 denote a valve of the pressurizer 32 and a valve of the containing vessel 30, respectively.

In accordance with the present invention, the ultra-hydrophilic Ti-O-C group compound thin film is continuously coated on the metal sheet 8 continuously supplied to the coating chamber 2 by using the plasma, and the thin film coated metal sheet 8 is mechanically processed into a target shape, for example, a fin of an air conditioning heat exchanger.

The ultra-hydrophilic metal sheet can be manufactured by using the plasma polymerization device. As mentioned above, the ultra-hydrophilic metal sheet is mechanically processed into the fin of the heat exchanger, and physical and surface properties thereof are measured and explained in the following examples. It must be recognized that the scope of the present invention is not restricted by the following examples but claims recited below.

### Examples

### Preparation of plasma coating film

After 0,133 Pa (10⁻³Torr) of vacuum was formed in the coating chamber 2 by using the vacuum pump 4, the metal sheet 8 was connected to an anode and maintained at a predetermined distance (30 to 150mm) from the electrodes 6, and the heater coil 42 of the bubbler 40 was electrically heated (80 to 120°C) to bubble the liquid-phase precursor. The hot wires 64 and 68 coiled around the outer walls of the tubes 60 and 66 were electrically heated (80 to 120°C) to prevent the titanium precursor from being condensed on the inner walls of the tubes 60 and 66. The gas-phase precursor gas, the carrier gas and the reactive gas were injected into the coating chamber 2 through the tube, and discharged in the up/down direction of the metal sheet 8.

Preferably, the gas-phase precursor gas and the carrier gas were injected into the coating chamber 2 at a ratio of 3 : 1, and the carrier gas and the reactive gas were injected into the coating chamber 2 at a ratio of 1 : 3.

When a target operation vacuum degree was obtained by the injected gas, the power was turned on, the metal sheet 8 was transferred in regard to the tube 60, and the plasma was continuously formed between the electrodes 6 by the mixed gas. Accordingly, the ultra-hydrophilic T i-O-C group compound thin film was coated on both surface of the metal sheet 6.

In the plasma treatment, the current was 1.2A 900V, the flux of the carrier gas that is He or Ar gas was 800sccm, the flux of the reactive gas that was oxygen or air was 1500sccm, the flux of the gas-phase precursor gas was 1000sccm, and the vacuum degree inside the chamber 2 ranged from 26,66 to 46,66 Pa (0.2 to 0.35Torr).

### Analysis of composition and thickness of coated thin film

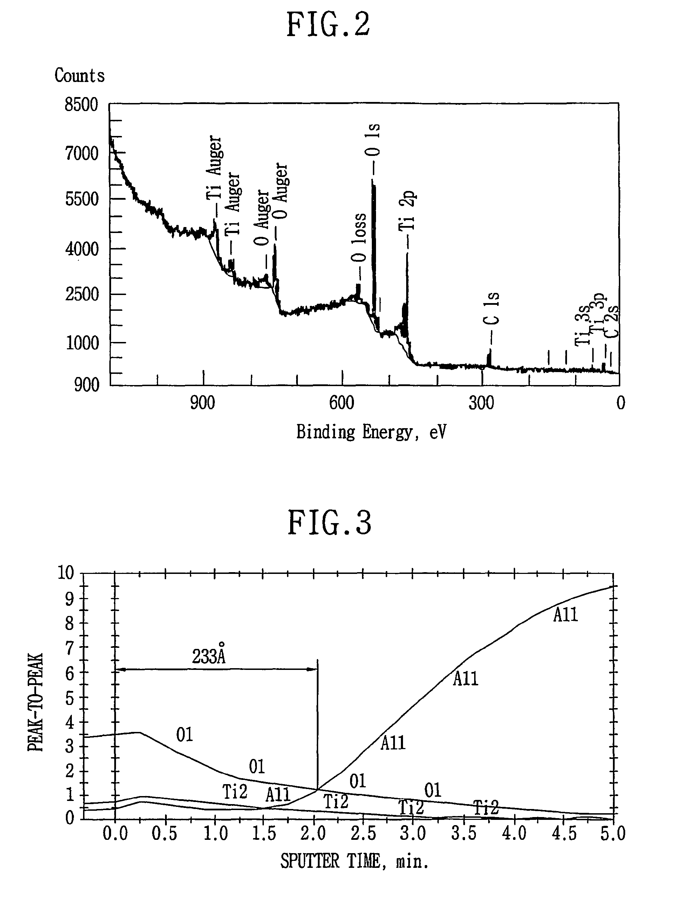

The composition of the processed thin film sample was analyzed according to X-ray photoelectric spectroscopy (XPS) for analogizing surface composition by measuring molecular specific absorption and emission wavelengths by using X-rays, and the thickness thereof was analyzed according to atomic emission spectrometry (AES) for analyzing composition by depth by performing sputtering at a fixed speed. Figs. 2 and 3 show the analysis results.

Fig. 2 is a graph showing XPS data when a titanium compound thin film was formed after an HMDSO anticorrosive thin film. 19.4 atomic% of C, 58.3 atomic% of O and 19.8 atomic% of Ti were analyzed. That is, the compound thin film was a Ti-O-C group compound thin film.

Although not illustrated, when only the ultra-hydrophilic compound thin film was coated, the Ti-O-C group compound thin film was prepared.

In accordance with the analysis results, although slightly varied upon the conditions, the titanium compound thin film commonly contains 15 to 22 atomic% of Ti, 45 to 65 atomic% of O, and 20 to 25 atomic% of C and optionally 20 atomic% of H.

Fig. 3 is a graph showing representative AES data. As described above, the AES, that analyzes composition by depth by performing sputtering at a fixed speed, can analyze the thickness of the thin film. In the AES data of Fig. 3, the thickness of the thin film was 23.3nm (233Å). The thickness of the Ti-O-C-(H) group compound thin film was restricted between 10 nm and 150 nm (100Å and 1500Å). Therefore, the preferable thickness of the Ti-O-C-(H) group compound thin film ranged from 1 to 100nm.

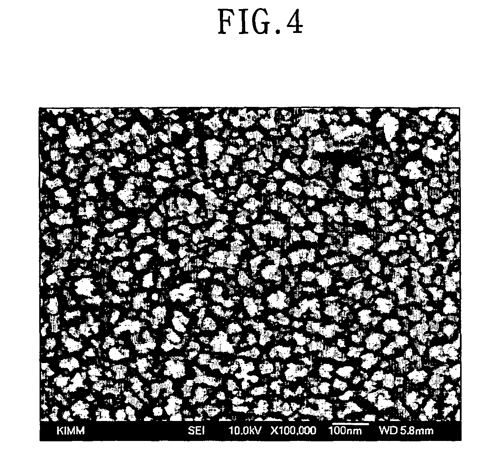

Fig. 4 is an SEM photograph showing the Ti-O-C group compound thin film in accordance with the present invention. As depicted in Fig. 4, a tight thin film was obtained with an amorphous structure.

### Hydrophilic and aging properties of thin film

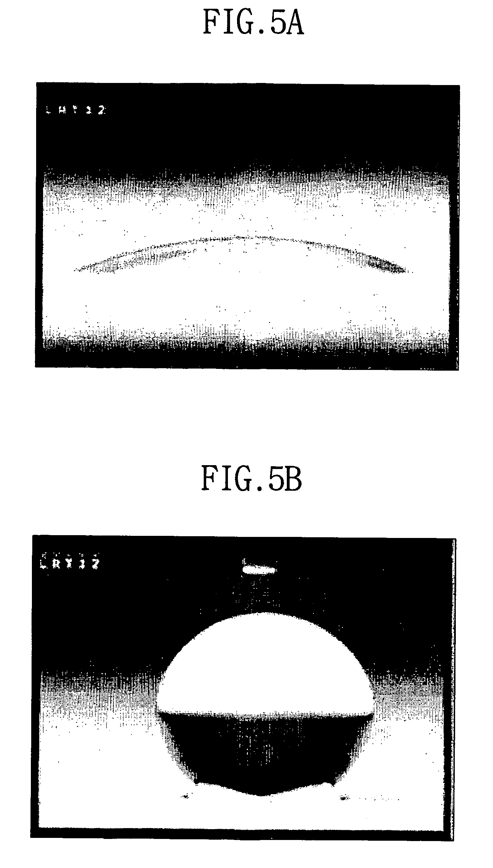

The hydrophilic performance test was executed by dropping a fixed quantity of droplets (0.1cc) from a height of 10mm, and measuring a size of droplets on the surface of the sample. When the surface of the film was hydrophilic, the size of the droplets increased due to high dispersion, and when the surface of the film was hydrophobic, the size of the droplets decreased due to low dispersion. Fig. 5a shows the droplet formed on the hydrophilic surface. The size of the droplet ranged from 9 to 11mm. Fig. 5b shows the droplet formed on the hydrophobic surface. The size of the droplet ranged from 2 to 3mm.

In order to evaluate the hydrophilic aging property, the samples were cyclically put into distilled water for 10 minutes and dried for 10 minutes. The hydrophilic performance of the initial samples was compared with that of the samples obtained after 300 cycles.

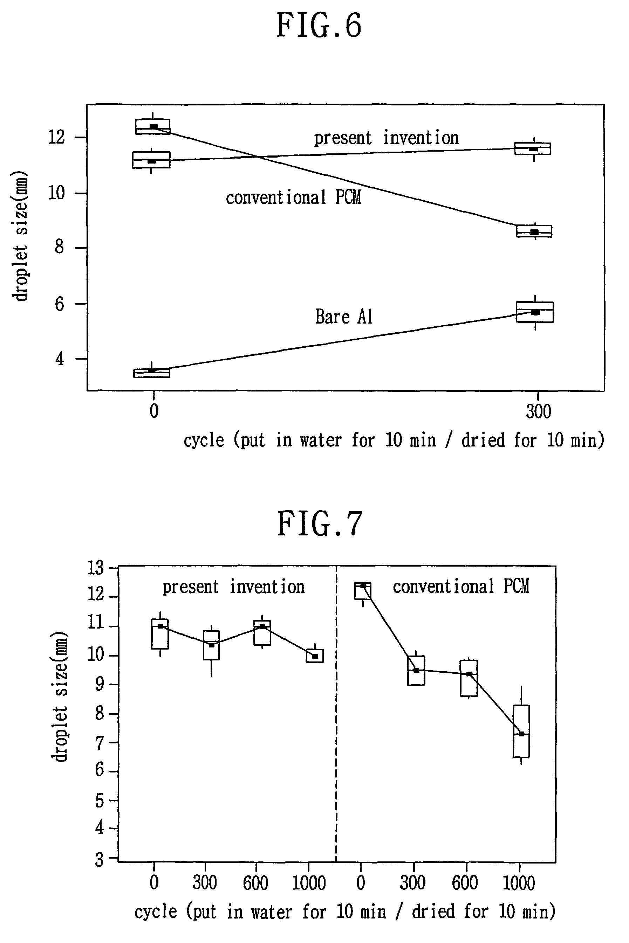

Fig. 6 is a graph showing the test results. The hydrophilic performance of the thin film of the present invention processed by the plasma was not changed after 300 cycle accelerations. On the other hand, the conventional PCM had excellent initial hydrophilic performance. As a surfactant that was a hydrophilic agent was dissolved in water, the hydrophilic performance of the conventional PCM was deteriorated. That is, the conventional PCM was aged. The Bare Al had a hydrophobic property at an initial stage. After accelerations, an Al₂O₃ layer was formed on the surface of the aluminum to slightly improve the hydrophilic performance.

Fig. 7 is a graph showing 1000 cycle aging test results of the titanium compound thin film of the present invention and the conventional PCM thin film. The thin film of the present invention maintained the hydrophilic performance (at least 9mm of droplets). On the other hand, the hydrophilic performance of the conventional PCM thin film was sharply deteriorated according to increase of cycles.

### Hydrophilic performance property by manufactured composition

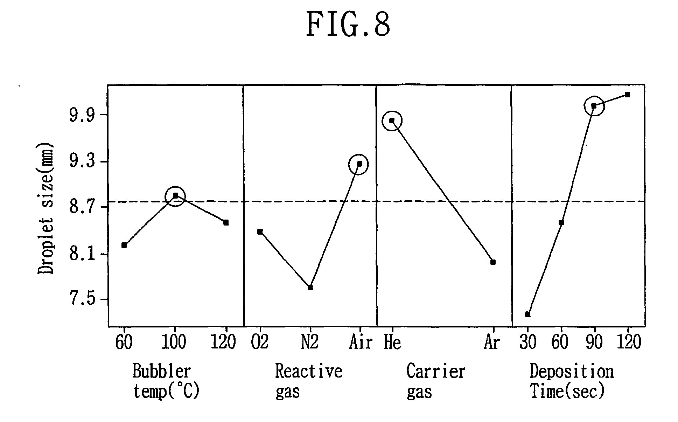

Fig. 8 is a graph showing hydrophilic performance test results of an Al sheet sample when a bubbler temperature, reactive gas, carrier gas and a deposition time were varied. That is, Fig. 8 shows size variations of the droplets by variations of each element.

The heating temperature of the bubbler 40 for bubbling the liquid-phase precursor was set as 60°C, 100°C and 120°C. The liquid-phase precursor heated and bubbled at 100°C had the highest hydrophilic performance (8.7mm).

The reactive gas was changed into O₂, N₂ and air. The sample using the air as the reactive gas had the highest hydrophilic performance (9.3mm).

The carrier gas was changed into He and Ar. The sample using He as the carrier gas had the highest hydrophilic performance (9.9mm).

The deposition time of the precursor gas was changed between 30 sec and 120 sec at an interval of 30 sec. The sample passing through 90 sec coating showed similar hydrophilic performance to that of the sample passing through 120 sec coating (9.9mm). Accordingly, the coating process was preferably performed for 90 sec, to maintain the hydrophilic performance and reduce the production time.

Here, the current of the electrodes 6 installed on both surfaces of the sample for forming the plasma was 0.13A, and the vacuum inside the coating chamber 2 housing the sample was maintained at 39,99 Pa (0.3Torr).

In order to efficiently manufacture the uitra-hydrophilic thin film coated metal product, the liquid-phase precursor was heated and bubbled at 100°C in the bubbler 40, the air was used as the reactive gas, He was used as the carrier gas, and the coating process was executed in the chamber 2 for 90 sec.

In the above test, the coating process was executed on the suitable sample. In the mass-production of the products, the heating temperature of the bubbler, the reactive gas, the carrier gas and the deposition time can be varied within the approximate range according to production environments and variable factors by continuous mass-production.

### Advantageous Effects

As discussed earlier, in accordance with the present invention, the air conditioning metal material coated with the thin film having excellent hydrophilic and aging properties can be easily produced on an industrial production scale.

In addition, the ultra-hydrophilic thin film can be uniformly formed on both surfaces of the sheet-shaped metal substrate.

Although the preferred embodiments of the present invention have been described, it is understood that the present invention should not be limited to these preferred embodiments.

## Claims

1. A method for manufacturing an ultra-hydrophilic thin film coated metal product, which continuously coats an ultra-hydrophilic Ti-O-C-(H) compound thin film containing 15 to 22 atomic% of Ti, 45 to 65 atomic% of O and 20 to 25% atomic% of C on both surfaces of a continuously-supplied sheet-shaped metal substrate in a vacuum chamber by using plasma, and mechanically processes the thin film coated sheet into a target shape.

2. The method of claim 1, wherein the thin film further contains H.

3. The method of claim 2, wherein the thin film contains 20 atomic% of H.

4. The method of any one of claims 1 to 3, wherein the thin film has a thickness of 1 to 100nm.

5. The method of any one of claims 1 to 4, wherein the metal substrate is an aluminum substrate.

6. The method of any one of claims 1 to 4, wherein the metal product is a fin for a heat exchanger.

7. The method of any one of claims 1 to 4, wherein the coating process is performed by injecting reactive gas, gas-phase titanium precursor and carrier gas into the vacuum chamber.

8. The method of claim 7, wherein the gas injection ratio satisfies carrier gas : reactive gas = 1 : 3.

9. The method of claim 7, wherein the gas injection ratio satisfies gas-phase titanium precursor: carrier gas = 3 : 1.

10. The method of any one of claims 7 to 9, wherein the reactive gas is air or O₂.

11. The method of any one of claims 7 to 9, wherein the carrier gas is selected from the group consisting of He, N₂ and Ar.

12. The method of any one of claims 7 to 9, wherein the gas-phase titanium precursor is prepared by passing liquid-phase titanium tetraisopropoxide through a bubbler.

13. The method of claim 12, wherein the injection amount of the gas-phase titanium precursor into the vacuum chamber is controlled by adjusting the amount of the liquid-phase titanium tetraisopropoxide supplied to the bubbler.

14. The method of any one of claims 7 to 9, wherein the carrier gas is injected before the liquid-phase titanium tetraisopropoxide is injected into the bubbler, for transferring the liquid-phase titanium tetraisopropoxide to the bubbler.

15. An ultra-hydrophilic thin film coated metal product, which is coated with an ultra-hydrophilic Ti-O-C-(H) compound thin film containing 15 to 22 atomic% of Ti, 45 to 65 atomic% of O and 20 to 25 atomic% of C at a thickness of 1 to 100nm by using plasma.

16. The metal product of claim 15, wherein the thin film further contains 20 atomic% of H.

17. The metal product of either claim 15 or 16, wherein the thin film has an amorphous structure.

18. The metal product of claim 17, wherein the metal sheet is an aluminum sheet.

19. The metal product of claim 18, wherein the thin film coated aluminum sheet is mechanically processed into a fin for a heat exchanger.

## Patentansprüche

1. Verfahren zur Herstellung eines mit einem ultrahydrophilen Dünnfilm beschichteten Metallprodukts, welches kontinuierlich mit einem ultrahydrophilen Ti-O-C-(H)-Verbindungs-Dünnfilm, enthaltend 15 bis 22 Atom-% Ti, 45 bis 65 Atom-% O und 20 bis 25 Atom-% C, beide Oberflächen eines kontinuierlich zugeführten blechförmigen Metallsubstrats in einer Vakuumkammer unter Verwendung von Plasma beschichtet und das mit Dünnfilm beschichtete Blech mechanisch zu einer Zielform verarbeitet

2. Verfahren nach Anspruch 1, wobei der Dünnfilm ferner H enthält.

3. Verfahren nach Anspruch 2, wobei der Dünnfilm 20 Atom-% H enthält

4. Verfahren nach irgendeinem der Ansprüche 1 bis 3, wobei der Dünnfilm eine Dicke von 1 bis 100 nm aufweist.

5. Verfahren nach irgendeinem der Ansprüche 1 bis 4, wobei das Metallsubstrat ein Aluminiumsubstrat ist

6. Verfahren nach irgendeinem der Ansprüche 1 bis 4, wobei das Metallprodukt eine Rippe für einen Wärmetauscher ist

7. Verfahren nach irgendeinem der Ansprüche 1 bis 4, wobei das Beschichtungsverfahren durch Einspritzen von Reaktivgas, Gasphasen-Titan-Vorläufer und Trägergas in die Vakuumkammer durchgeführt wird

8. Verfahren nach Anspruch 7, wobei das Gaseinspritzverhältnis Trägergas : Reaktivgas = 1 : 3 entspricht.

9. Verfahren nach Anspruch 7, wobei das Gaseinspritzverhältnis Gasphasen-Titan-Vorläufer Trägergas =3 : 1 entspricht.

10. Verfahren nach irgendeinem der Ansprüche 7 bis 9, wobei das Reaktivgas Luft oder O₂ ist

11. Verfahren nach irgendeinem der Ansprüche 7 bis 9, wobei das Trägergas aus der Gruppe bestehend aus He, N₂ und Ar ausgewählt wird

12. Verfahren nach irgendeinem der Ansprüche 7 bis 9, wobei der Gasphasen-Titan-Vorläufer durch Durchleiten von Flüssigphasen-Titantetraisopropoxid durch einen Bubbler hergestellt wird

13. Verfahren nach Anspruch 12, wobei die Einspritzmenge des Gasphasen-Titan-Vorläufers in die Vakuumkammer durch Einstellen der dem Bubbler zugeführten Menge des Flüssigphasen-Titantetraisopropoxids geregelt wird

14. Verfahren nach irgendeinem der Ansprüche 7 bis 9, wobei das Trägergas eingespritzt wird, bevor das Flüssigphasen-Titantetraisopropoxid in den Bubbler eingespritzt wird, um das Flüssigphasen-Titantetraisopropoxid zum Bubbler zu übertragen

15. Mit ultrahydrophilem Dünnfilm beschichtetes Metallprodukt, welches mit einem ultrahydrophilen Ti-O-C-(H)-Verbindungs-Dünnfilm, enthaltend 15 bis 22 Atom-% Ti, 45 bis 65 Atom-% O und 20 bis 25 Atom-% C, bei einer Dicke von 1 bis 100 nm unter Verwendung von Plasma beschichtet ist

16. Metallprodukt nach Anspruch 15, wobei der Dünnfilm ferner 20 Atom-% H enthält

17. Metallprodukt nach Anspruch 15 oder 16, wobei der Dünnfilm eine amorphe Struktur aufweist.

18. Metallprodukt nach Anspruch 17, wobei das Metallblech ein Aluminiumblech ist

19. Metallprodukt nach Anspruch 18, wobei das mit Dünnfilm beschichtete Aluminiumblech mechanisch zu einer Rippe für einen Wärmetauscher verarbeitet ist

## Revendications

1. Procédé pour la fabrication d'un produit métallique enduit d'un film mince ultra-hydrophile, dans lequel on enduit en continu un film mince à base d'un composé de Ti-O-C-(H) ultra-hydrophile contenant du Ti à concurrence de 15 à 22 atomes %, du O à concurrence de 45 à 65 atomes % et du C à concurrence de 20 à 20 atomes %, sur les deux surfaces d'un substrat métallique en forme de feuille, acheminé en continu dans une chambre de vide en utilisant du plasma, et dans lequel on soumet la feuille enduite du film mince à un traitement mécanique pour obtenir une configuration cible

2. Procédé selon la revendication 1, dans lequel le film mince contient en outre de l'hydrogène

3. Procédé selon la revendication 2, dans lequel le film mince contient du H à concurrence de 20 atomes %

4. Procédé selon l'une quelconque des revendications 1 à 3, dans lequel le film mince possède une épaisseur de 1 à 100 nm.

5. Procédé selon l'une quelconque des revendications 1 à 4, dans lequel le substrat métallique est un substrat en aluminium

6. Procédé selon l'une quelconque des revendications 1 à 4, dans lequel le produit métallique est une ailette pour un échangeur de chaleur

7. Procédé selon l'une quelconque des revendications 1 à 4, dans lequel le procédé d'enduction est mis en oeuvre en injectant un gaz réactif, un précurseur de titane en phase gazeuse et un gaz porteur dans la chambre de vide

8. Procédé selon la revendication 7, dans lequel le rapport d'injection de gaz satisfait à l'équation : gaz porteur : gaz réactif = 1 : 3

9. Procédé selon la revendication 7, dans lequel le rapport d'injection de gaz satisfait à l'équation : précurseur de titane en phase gazeuse : gaz porteur = 3 : 1

10. Procédé selon l'une quelconque des revendications 7 à 9, dans lequel le gaz réactif est de l'air ou du O₂.

11. Procédé selon l'une quelconque des revendications 7 à 9, dans lequel le gaz porteur est choisi parmi le groupe constitué par He, N₂ et Ar.

12. Procédé selon l'une quelconque des revendications 7 à 9, dans lequel on prépare le précurseur de titane en phase gazeuse en faisant passer du tétraisopropoxyde de titane en phase liquide à travers un barboteur

13. Procédé selon la revendication 12, dans lequel la quantité d'injection du précurseur de titane en phase gazeuse dans la chambre de vide est contrôlée en réglant la quantité du tétraisopropoxyde de titane en phase liquide acheminée au barboteur

14. Procédé selon l'une quelconque des revendications 7 à 9, dans lequel le gaz porteur est injecté avant l'injection du tétraisopropoxyde de titane en phase liquide dans le barboteur pour transférer le tétraisopropoxyde de titane en phase liquide au barboteur

15. Produit métallique enduit d'un film mince ultra-hydrophile, qui est enduit avec un film mince à base d'un composé de Ti-O-C-(H) ultra-hydrophile, qui contient du Ti à concurrence de 15 à 22 atomes %, du O à concurrence de 45 à 65 atomes % et du C à concurrence de 20 à 25 atomes %, à raison d'une épaisseur de 1 à 100 nm en utilisant un plasma

16. Produit métallique selon la revendication 15, dans lequel le film mince contient en outre du H à concurrence de 20 atomes %

17. Produit métallique selon l'une quelconque des revendications 15 ou 16, dans lequel le film mince possède une structure amorphe

18. Produit métallique selon la revendication 17, dans lequel la feuille métallique est une feuille en aluminium

19. Produit métallique selon la revendication 18, dans lequel la feuille en aluminium enduite du film mince est soumise à un traitement mécanique pour obtenir une ailette destinée à un échangeur de chaleur.
